# EUROPEAN PATENT SPECIFICATION

(11) **EP 2 297 763 B1**
(45) Date of publication and mention of the grant of the patent: **06.07.2016**
(21) Application number: 09754346.6
(22) Date of filing: 31.05.2009
(51) Int. Cl.: H01J 49/06, H01J 3/14, H01J 37/244

(54) **CHARGED PARTICLE DETECTION SYSTEM AND METHOD**
SYSTEM UND VERFAHREN ZUR DETEKTION GELADENER TEILCHEN
SYSTÈME ET PROCÉDÉ DE DÉTECTION DE PARTICULES CHARGÉES

(30) Priority: 30.05.2008 US 155233
(43) Date of publication of application: 23.03.2011
(73) Proprietor: El-Mul Technologies Ltd, 81104 Yavne (IL)
(72) Inventor: SHOFMAN, Semyon, Qiriat Ekron 70500 (IL); CHEIFETZ, Eli, Ramat-Gan 52514 (IL); SCHON, Armin, Nes-Ziona 74057 (IL); PINHASI, Eitan, Jerusalem 96581 (IL)
(74) Representative: Hahn, Christian
(86) International application number: PCT/IL2009/000534
(87) International publication number: WO 2009/144727

(56) References cited:
- EP-A1- 0 278 034
- WO-A1-2008/025135
- GB-A- 1 576 915
- JP-A- 63 071 680
- US-A- 3 898 456
- US-A- 5 026 988
- US-A- 5 160 840
- US-A- 5 202 561
- US-A1- 2004 262 531
- US-A1- 2006 289 748
- US-B2- 6 940 066

## Description

### REFERENCE TO CO-PENDING APPLICATIONS

Applicant hereby claims priority of U. S. Patent Application Serial No. 12/155,233, filed on May 30, 2008, entitled "Three Modes Particle Detector".

### FIELD OF THE INVENTION

The present invention generally relates to a charged particle detection system and method, in particular to a particle detection system capable of detecting electrons, positive ions and negative ions.

### BACKGROUND OF THE INVENTION

Electrons, positive ions and negative ions are charged particles that can be emitted from a sample upon irradiation thereof by a focused ion beam. Particle detectors, which can detect both positively charged particles and negatively charged particles, are well known. These detectors typically comprise a scintillator element, which is excited by electrons that are emitted from the sample and/or generated by conversion of ions to electrons by an ion-to-electron converter. The converters used in the devices of the kind specified are designed in such a way that positive ions are allowed to impinge upon surfaces of the ion-to-electron converter and cause emission of secondary electrons from the conversion surfaces of the converter, while negatively charged particles bypass the conversion surfaces without interacting with these surfaces.

Publication JP 63 07 1680 A discloses a detector to improve detection limit and sensitivity and to enable detection of both positive and negative ions with the same gain by disposing a meshed electrode between an ion-electron converter and scintillator and forming a curved shape to focus secondary electrons to a scintillator surface by using the surface of the meshed electrode and the surface of the scintillator. The surfaces of the meshed electrode and the scintillator are shaped to the spherical surface having the same center so as to focus the secondary electrons generated by the ion-electron converter onto an aluminum film.

US Patent No. 5 202 561 discloses a detector device for analyzing ions of high mass using a time-of-flight (TOF) analytical method, consisting of a mass spectrometer, accelerating electrodes and a magnetic field and/or electric field, all of which serves to deflect secondary ions emerging from a first conversion dynode, so that the secondary ions impinge according to polarity on a second and third conversion dynode.

US Patent No. 3 898 456 relates to an improved ion detector for use in mass spectrometers for pulse counting single ions which may have a positive or a negative charge. The invention combines a novel electron multiplier with a scintillator type of ion detector. It is a high vacuum, high voltage device intended for use in ion microprobe mass spectrometers.

Publication EP 0 278 034 A1 discloses a detector for detecting charged particles, the detector comprises a secondara electron multiplier for converting the charged particles into secondary electrons and amplifying the secondary electrons, a scintillator for converting the secondary electrons generated from the secondary electron multipler into light, and a photomultiplier for receiving the light.

### GENERAL DESCRIPTION

The present invention provides a novel particle detection system capable of detecting electrons, positive ions and negative ions.

The conventional particle detectors utilize ion-to-electron converters and are configured to allow positive ion interaction with the conversion surfaces of the converter while preventing negative ion and electron interaction with such surfaces. However, with the conventional approach, negative ions pass through a detector and impinge directly upon the surface of a scintillator element thus shortening the scintillator element surface life.

The invented approach provides for solving the above problem. Also, the invention provides for utilizing the ion-to-electron converter for converting electrons originating from a sample to secondary electrons, in addition to converting the positive and negative ions to electrons, thereby amplifying the number of electrons to be detected by the detector.

There is thus provided a charged particle detection device and system according to claims 1 and 7, respectively, and a method for use in detecting charged particles according to claim 10. Advantageous embodiments of the invention are set out in the dependent claims.

### RIEF DESCRIPTION OF THE DRAWINGS

The present invention will be understood and appreciated more folly from the following detailed description, taken in conjunction with the drawings in which
Fig. 1 is a schematic illustration of an example of a charged particle detection system according to the invention;
Fig. 2 is a simplified sectional illustration of a particle detection system constructed and operative in accordance with an embodiment of the present invention;
Fig. 3 is a simplified sectional illustration of a particle detection system constructed and operative in accordance with another embodiment of the present invention;
Fig. 4 is a simplified sectional illustration of a particle detection system constructed and operative in accordance with yet another embodiment of the present invention; and
Fig. 5 is a simplified sectional illustration of a particle detection system constructed and operative in accordance with still another embodiment of the present invention.

### DETAILED DESCRIPTION OF EMBODIMENTS

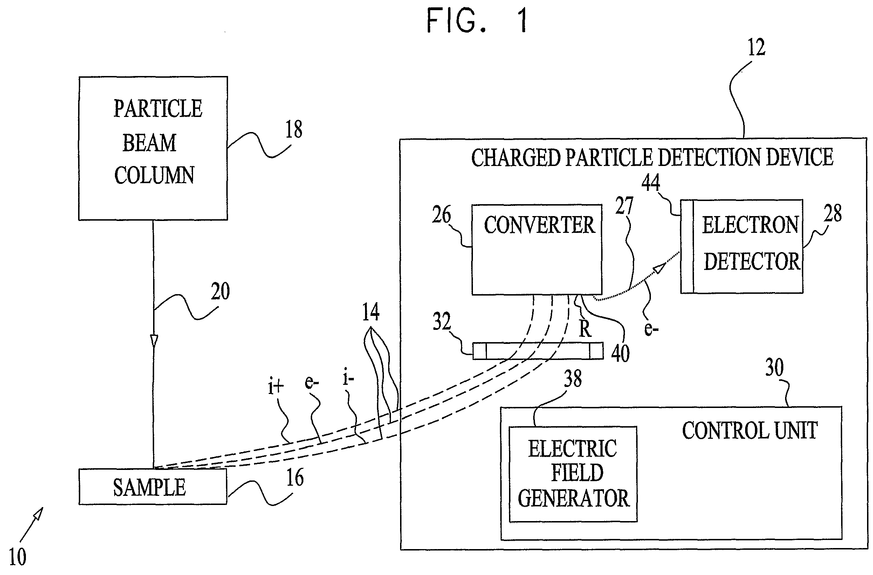

Referring to Fig. 1, there is illustrated, by way of a block diagram, an example of a charged particle detection system 10 configured and operable according to the invention. System 10 comprises a charged particle detection device 12 configured according to the invention for detecting charged particle(s) 14 of different types emitted from a sample 16, and a particle beam column 18. Particle beam column 18 may comprise a focused ion beam (FIB) column, a dual beam column, an electron beam column, a helium beam column or any other suitable particle beam column. The charged particle detectable by detection device **12** is an electron, a positive ion or a negative ion. A particle beam **20,** generated by column **18,** irradiates the sample **16** causing charged particle (positive/negative ion and/or electron) emission from the sample **16.** The emitted particle propagates towards detection device **12.**

As will be described further below, the detection device **12** is operable in three modes for detecting positive and negative ions and electrons, respectively, depending on a generated electric field. The detection device **12** comprises a converter **26** for generating electrons **27** in response to interaction with incident charged particles **14,** an electron detector **28,** and a control unit **30.** Optionally, the detection system **10** comprises a grid electrode **32** accommodated in the path of charged particles emitted from the same, e.g. upstream of the converter **26** with respect to propagation of the charged particle trajectories. Grid **32** may or may not be a constructional part of the detection device **12.**

The control unit **30** comprises an electric field generator **38,** which may be referred to as an electrical biasing assembly, configured and operable for creating an appropriate electric field within the detection device **12** to thereby define trajectories for charged particle (i.e. for positive and negative ion and for electron) propagation towards detector **28.** Electric field generator **38** thus comprises a voltage supply unit (not shown) to supply/maintain appropriate voltages to converter **26** and detector **28** and also to grid **32** if such grid is used in the detection device **12.**

The converter **26** has a charged particle conversion surface **40** which has a continuous surface interaction region **R** oriented to intersect the trajectories of charged particles of different types. Conversion surface **40** (at least within the interaction region **R**) is adapted for emitting electrons in response to interaction with incident charged particle(s). Electron detector **28** has a scintillator element surface **44** exposed to electron output from the converter **26.** With such appropriately oriented continuous interaction region **R,** the electric field created within the detection device **12** defines an operational mode of the device to selectively allow detection of the charged particles of any type by the electron detector **28.**

It is appreciated that electron detector **28** may be of any suitable configuration for receiving electrons and generating output data indicative thereof. For example, a Multi-Channel-Plate (MCP) or a Solid State Diode (SSD) may be employed. Alternatively, a CHANNELTRON® detector may be employed and may be commercially available at Burle Industries, Inc. of 1000 New Holland Avenue, Lancaster, PA 17601-5688 U.S.A.

Detection device **12** thus operates as a triple mode particle detection device. As will be described more specifically further below, converter **26** is electrically biasable for selectively attracting a charged particle and electron detector **28** is electrically biasable with respect to converter **26** so as to detect the electron emitted from the conversion surface **40.**

In a non-limiting example, the scintillator element surface **44** of the electron detector **28** may be set to a positive high potential typically in the range of approximately 7kV-12kV. The converter **26** may be set to a positive or negative potential with a fixed proportion factor relative to the grid **32.** The fixed proportion factor may be larger than 1, such as approximately 1.4, for example.

The converter **26** and detector **28** (its scintillator element surface **44**), as well as grid **32** if used, may be each set at a different electrical potential to create an appropriate electric field defining the trajectories of the different-type charged particles so as to selectively facilitate detection of a positive ion in a positive ion detection mode, a negative ion in a negative ion detection mode, and an electron in an electron detection mode. For example, to facilitate the positive ion detection mode, grid **32** may be set to an electrical potential of approximately -2.7 kV, converter **26** may be set to an electrical potential of approximately -3.8 kV and the scintillator element surface **44** may be set to an electrical potential of approximately +10 kV. To implement the negative ion detection mode, grid **32** may be set to an electrical potential of approximately +2.7 kV, converter **26** may be set to an electrical potential of approximately +3.8 kV and the scintillator element surface **44** may be set to an electrical potential of approximately +10 kV. In the electron detection mode, grid **32** may be set to an electrical potential of approximately +1 kV, converter **26** may be set to an electrical potential of approximately +1.4 kV and the scintillator element surface **44** may be set to an electrical potential of approximately +10 kV.

It is appreciated that grid **32,** if used, may be located at any suitable location. The provision of the grid **32** is optional. The desired electric fields can be created by appropriate potentials on the converter **26** and detector **28** (to ensure that a particle **14** emitted from a sample **16** impinges upon the conversion surface **40** of the converter **26,** and also to ensure that electrons **27** from the converter **26** are directed to the detector **28**). The following description comprises some specific but non limiting examples of the configuration of the detection system according to the invention.

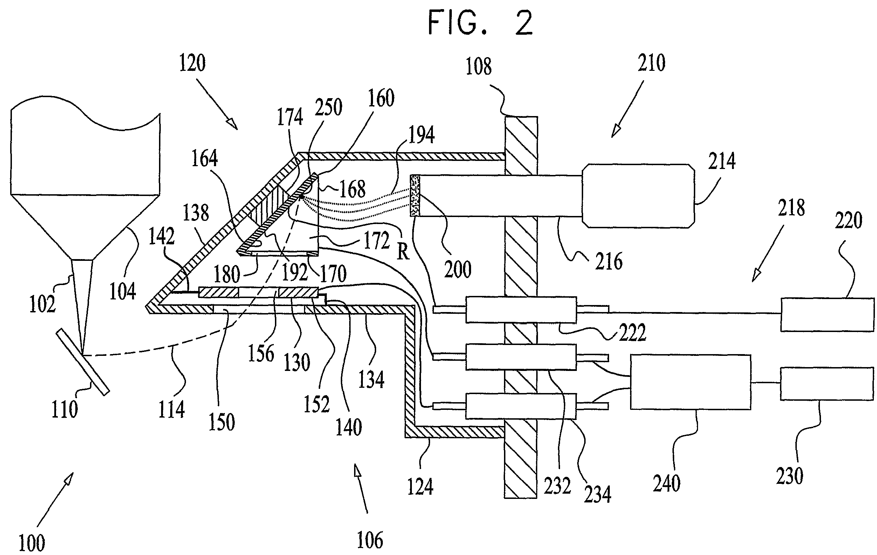

Reference is made to **Fig. 2****,** which is a simplified sectional illustration of a particle detection system **100** constructed and operative in accordance with an embodiment of the present invention. Particle detection system **100** comprises a particle beam **102** generated by a beam column **104,** and a charged particle detection device, also referred to as a triple mode particle detection device, which in the present example is located within a detection system chamber **106** having walls **108.** The particle beam **102** generated by column **104** irradiates a sample **110** thus urging one or more charged particles **114** to be emitted therefrom. The emitted charged particles **114** may comprise an electron, positive ion and/or a negative ion. As indicated above, beam column **104** may comprise a focused ion beam (FIB) column, a dual beam column, an electron beam column, a helium beam column or any other suitable particle beam column.

A particle detection device **120** is enclosed in a housing **124** formed of any suitable conductive material. Preferably, housing **124** is set to an electrical potential of the detection system chamber **106.** Optionally, a grid **130** is provided in the detection device, e.g. being mounted to walls **134** and **138** of the housing **124** in any suitable manner, e.g. using mounting elements **140** and **142.** Mounting elements **140** and **142** may be formed of any suitable material, typically an insulating material, such as Ertalyte® which may be commercially available at Modem Plastics of 678 Howard Avenue, Bridgeport, Connecticut, USA.

Housing **124** has an aperture **150** in its wall **134** for a charged particle **114** to pass therethrough. Thus, charged particle **114** is urged to pass the housing aperture **150** and reach grid **130** while the electric field in the detection device is such as to attract the particle towards the grid **130** (the grid **130** is electrically biased at a potential operative to attract the charged particle **114** thereto). Grid **130** may be formed of any suitable conductive material, such as stainless steal. The grid **130** may define a planar surface **152** or any other suitable geometry, such as a curved surface, a mash, an array of spaced apart elements or any configuration operative to allow a particle to pass therethrough.

The charged particle **114** passes grid **130,** via a grid space/aperture **156,** preferably configured at a central location of planer surface **152,** and propagates to a converter **160.** Converter **160** may have any suitable configuration such that a conversion surface **164** thereof, or at least an interaction region **R** thereof, is located in the propagation path of the charged particles of different types. As seen in **Fig. 2****,** a cross section of converter **160** may have a right triangle geometry with conversion surface **164** defined by a hypotenuse surface between side supports **168.** Converter **160** may include a bottom support **170,** thus defining a converter vicinity **172** therein for charged particle passage therethrough away from the conversion surface **164.** Bottom support **170** is formed with an aperture **180** for charged particle passage therethrough towards the conversion surface **164.** Converter **160** may be mounted to housing **124** in any suitable manner, such as by a mounting element **174** affixing conversion surface **164** to housing wall **138.** Mounting element **174** may be formed of any suitable material, typically an insulating material, such as Ertalyte® which may be commercially available at Modem Plastics of 678 Howard Avenue, Bridgeport, Connecticut, USA.

Any suitable material for allowing high electron emission may be used for the conversion surface **164** of converter **160,** such as aluminum covered by a thin layer of aluminum oxide, for example.

A control unit **(****Fig. 1****),** namely its electric field generator operates to create an appropriate electric field to direct charged particle **114** towards the converter **160,** i.e. converter **160** is electrically biased at a potential operative to attract the charged particle **114** thereto such that the charged particle **114** passes aperture **180** and impinges upon conversion surface **164** within the interaction region **R** at its surface side **192.** Consequentially, a plurality of electrons **194** are emitted from conversion surface **164** at the same surface side **192.** Thus, converter **160** operates as an ion-to-electron converter whereupon the charged particle **114** is a positive ion or a negative ion. Additionally, the same conversion surface operates as a particle **114** amplifier. For example, three electrons **194** may be emitted upon impingement of a single particle **114** on conversion surface **164.**

The so-emitted electrons **194** pass vicinity **172** and propagate towards a scintillator element surface **200** of an electron detector **210.** The scintillator element surface **200** may be coupled to a light sensor, such as a photomultiplier tube (PMT) **214** via a light guide **216** thereby yielding an electrical signal from electron detector **210.**

As described hereinabove, the grid **130,** converter **160** and scintillator element surface **200** are electrically biased so as to create an electric field capable of urging charged particle **114** of a specific type emitted from sample **110** to pass grid **130** onto converter **160** and to attract resultant electrons emitted from converter **160** to scintillator element surface **200.** It should be understood that grid **130,** converter **160** and scintillator element surface **200** may be electrically biased in any suitable manner. Also, provision of grid **130** is optional. In the case no grid is used the electric field is defined by voltage on the converter **160** and scintillator element surface **200.**

In the embodiment shown in **Fig. 2****,** an electrical biasing assembly **218** of control unit comprises a switchable high voltage power supply **220** coupled to a first voltage feedthrough **222** in electrical communication with scintillator element surface **200** so as to electrically bias scintillator element surface **200,** and a switchable high voltage bipolar power supply **230** coupled to a second and a third voltage feedthrough **232** and **234,** respectively, via a voltage divider **240.** Second voltage feedthrough **232** is in electrical communication with converter **160** so as to electrically bias converter **160,** and third voltage feedthrough **234** is in electrical communication with grid **130** so as to electrically bias grid **130.**

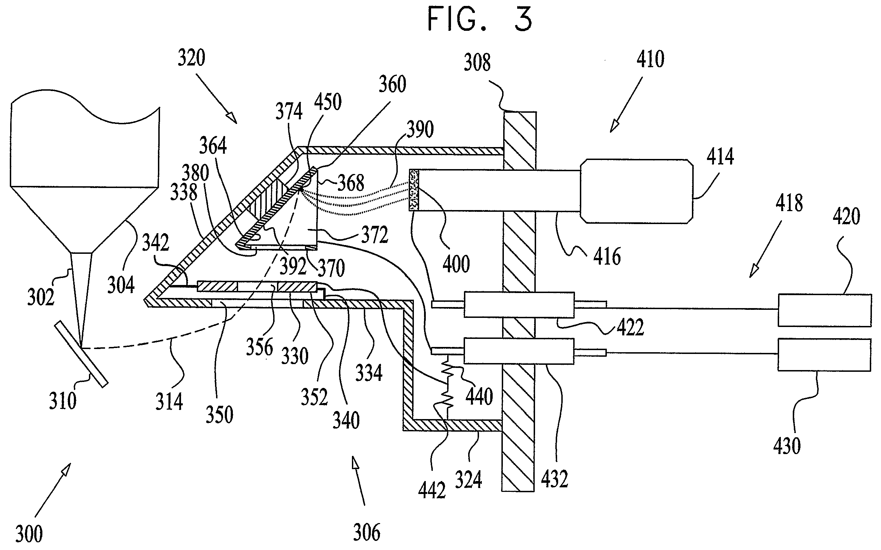

It is appreciated that electrical biasing assembly **218** may be configured in any suitable configuration, such as will be exemplified hereinbelow with reference to **Fig. 3****.** Alternatively, a plurality or single voltage power supply may be provided. The control unit may be located within particle detection system **100** or may be located externally to particle detection system **100** and is in electrical communication therewith. Additionally, the voltage power supply and/or the voltage divider may be located within particle detection system **100** or may be located externally to particle detection system **100** and are in electrical communication therewith.

The converter **160** (and also grid **130** if used) is positioned relative to sample **110** and is electrically biased so as to ensure that a charged particle **114** emitted from sample **110** is attracted to the interaction region **R** within the conversion surface of converter **160.** Additionally, the converter **160** (and grid **130** if used) may be positioned relative to sample **110** and the converter **160** and scintillator element surface **200** are electrically biased so as to ensure that a charged particle **114** impinges upon the interaction region within the conversion surface **164** at a location where an attraction force generated by scintillator element surface **200** is greatest so as to ensure that a resultant electron emitted from conversion surface **164** is attracted to scintillator element surface **200.** This location, designated by reference numeral **250** in **Fig. 2****,** is proximal to the scintillator element surface **200.**

It is appreciated that grid **130** may be located at any suitable location inside or outside the housing **124.** Additionally, grid **130** may be obviated and converter **160** may be thus electrically biased so as to ensure that a particle **114** emitted from sample **110** will impinge upon conversion surface **164.**

It is noted that features described in reference to **Fig. 1** may be identical to features described in reference to **Fig. 2****.**

Reference is now made to **Fig. 3****,** which is a simplified sectional illustration of a particle detection system **300** constructed and operative in accordance with another embodiment of the present invention. Particle detection system **300** comprises a particle beam **302** generated by a particle beam column **304** which in the present example is located within a detection system chamber **306** defined by chamber walls **308,** and a triple mode particle detection device. The particle beam **302** generated by column **304** irradiates a sample **310** thus causing a charged particle **314** to be emitted therefrom. The charged particle **314** may be an electron, positive ion or a negative ion. Beam column **304** may comprise an FIB column, a dual beam column, an electron beam column, a helium beam column or any other suitable particle beam column.

Triple mode particle detection device **320** comprises a housing **324,** and optionally comprises a grid **330** which may be located inside or outside the housing **324.** The housing is formed of any suitable conductive material, and is preferably set to an electrical potential of the detection system chamber **306.** In the present example, grid **330** is located inside the housing **324** being appropriately mounted to housing walls **334** and **338,** e.g. using mounting elements **340** and **342.** Charged particle **314** is directed, by electric field in the detection device, to pass a housing aperture **350** in wall **334** and reach grid **330** which is electrically biased at a potential operative to attract the charged particle **314** thereto. As indicated above, grid **330** may be formed of any suitable conductive material, such as stainless steal, and may define any suitable configuration such as a planar surface or a curved surface **352** allowing a particle **314** to pass through grid aperture/space **356.** The latter is preferably configured at a central location of planer surface **352.**

Charged particle **314** passes through grid **330** toward a converter **360.** Converter **360** may have any suitable configuration. As exemplified in **Fig. 3****,** converter **360** has a geometry similar to that of **Fig. 2****,** namely having a right triangle cross section with a conversion surface **364,** defined by a hypotenuse surface, between side supports **368.** Converter **360** may include a bottom surface **370** thus defining a converter vicinity therein **372** for charged particle passage therethrough away from the conversion surface **364.** Bottom support **370** is formed with an aperture **380** for charged particle passage therethrough towards the conversion surface **364.** Converter **360** may be mounted to housing **324** by a mounting element **374** affixing conversion surface **364** to housing wall **338.** Any suitable material for allowing high electron emission may be used for the conversion surface of converter **360,** such as aluminum covered by a thin layer of aluminum oxide, for example.

Converter **360** is electrically biased at a potential operative to attract the charged particle **314** thereto such that the charged particle **314** passes aperture **380** and impinges upon conversion surface **364.** Consequentially, a plurality of electrons **390** are emitted from conversion surface **364** at the same surface side **392** onto which the charged particle **314** was incident. Thus, converter **360** operates as an ion-to-electron converter whereupon the charged particle **314** is a positive ion or a negative ion. Additionally, the same conversion surface operates as a particle **314** amplifier. For example, three electrons **390** may be emitted upon impingement of a single particle **314** on conversion surface **364.**

Electrons **390** pass vicinity **372** and impinge upon a scintillator element surface **400** of an electron detector **410.** The scintillator element surface **400** may be coupled to a light sensor, such as a PMT **414** via a light guide **416** thereby yielding an electrical signal from electron detector **410.**

As described hereinabove, converter **360** and scintillator element surface **400** (and also grid **330** if used) are electrically biased so as to cause a charged particle **314** emitted from sample **310** to pass to converter **360** (e.g. through grid **330**) and to attract resultant electrons emitted from converter **360** to scintillator element surface **400.** In the embodiment shown in **Fig. 3****,** an electrical biasing assembly **418** comprises a switchable high voltage power supply **420** coupled to a first voltage feedthrough **422** in electrical communication with scintillator element surface **400** so as to electrically bias scintillator element surface **400,** and a switchable high voltage power supply **430** coupled to a second voltage feedthrough **432** which is in electrical communication with converter **360.** Resistors **440** and **442** may be provided so as to allow voltage fed via voltage feedthrough **432** to be divided between grid **330** and converter **360** in order to electrically bias them. As seen in **Fig. 3****,** resistors **440** are interconnected between housing **324** and second voltage feedthrough **432.** Resistor **440** may be of approximately 2.5GΩ resistance and resistor **442** may be of approximately 1GΩ resistance. It is appreciated that a multiplicity of resistors may be utilized and may be located at various locations within detection device **320** at various degrees of resistance.

Thus, the converter **360** is positioned relative to sample **310** and is electrically biased to ensure that a particle **314** emitted from sample **310** will be attracted to converter **360** (e.g. assisted by grid **330**) and thereby impinge upon conversion surface **364.** Additionally, the converter **360** (and grid **330**) may be positioned relative to sample **310** and electrically biased to ensure that a particle **314** interacts with the conversion surface **364** at a location wherein an attraction force generated by scintillator element surface **400** is greatest so as to ensure that a resultant electron emitted from converter **360** is attracted to scintillator element surface **400.** This location **450** is proximal to the scintillator element surface **400.**

As indicated above, grid **330** may be located at any suitable location inside or outside the housing **324.** Additionally, grid **330** may not be used at all and converter **360** may be thus electrically biased so as to ensure that a particle **314** emitted from sample **310** interacts with conversion surface **364.**

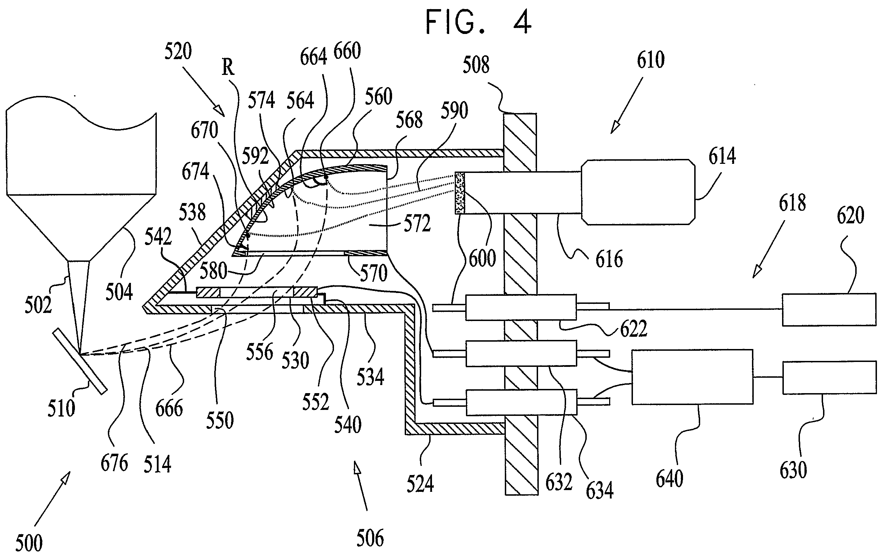

Reference is now made to **Fig. 4****,** which is a simplified sectional illustration of a particle detection system **500** constructed and operative in accordance with yet another embodiment of the present invention. Particle detection system **500** is configured generally similar to the above-described examples, namely comprising a particle beam **502** generated by a particle beam column **504** and a triple mode particle detection device **520.** Column **504** may comprise an FIB column, a dual beam column, an electron beam column, a helium beam column or any other suitable particle beam column. Column **504** is located within a detection system chamber **506** defined by chamber walls **508,** and operates to generate particle beam **502** to irradiate a sample **510** thus causing emission of a charged particle **514** (an electron, positive ion or a negative ion) from the sample **510.**

Similar to the above examples, the detection device **520** has a housing **524** (formed of any suitable conductive material and is preferably set to an electrical potential of the detection system chamber **506**) having an aperture **550** defined within a wall **534,** optionally comprises a grid **530** (e.g. mounted to housing walls **534** and **538** by respective mounting elements **540** and **542**), and comprises an electron detector **610.** Charged particle **514** is urged to pass through aperture **550** towards grid **530,** electrically biased at an appropriate potential operative to attract the charged particle **514** thereto, and to pass through a grid aperture/space **556** (e.g. at a central location of a planer surface **552** of the grid **530**) to a converter **560.** In the present non-limiting example, converter **560** has a curved conversion surface **564** between side supports **568.** Converter **560** may include a bottom surface **570** defining a converter vicinity **572** for charged particle passage therethrough away from the conversion surface **564.** Bottom support **570** is formed with an aperture **580** for charged particle passage therethrough towards the conversion surface **564.** Converter **560** may be mounted to housing **524** by a mounting element **574** affixing conversion surface **564** to housing wall **538.** Conversion surface **564** may be made of any suitable material allowing high electron emission therefrom, such as aluminum covered by a thin layer of aluminum oxide, for example.

In order to create an appropriate electrical field within the detection device, converter **560** is electrically biased at a potential operative to attract the charged particle **514** thereto such that the charged particle **514** passes aperture **580** and impinges upon conversion surface **564** at its surface side **592** resulting in emission of a plurality of electrons **590** from conversion surface **564** at the same surface side **592.** Thus, converter **560** operates as an ion-to-electron converter whereupon the charged particle **514** is a positive ion or a negative ion. Additionally, the same conversion surface operates as a particle **514** amplifier. For example, three electrons **590** may be emitted upon impingement of a single particle **514** on conversion surface **564.**

Electrons **590** pass vicinity **572** and impinge upon a scintillator element surface **600** of electron detector **610.** As indicated above, the scintillator element surface **600** may be coupled to a light sensor, such as a PMT **614** via a light guide **616** thereby yielding an electrical signal from electron detector **610.**

As described hereinabove, converter **560** and scintillator element surface **600** (and grid **530** if used) are electrically biased so as to direct a charged particle **514** emitted from sample **510** towards an interaction region within the conversion surface of converter **560** (e.g. via grid **530**) and to attract resultant electrons **590,** emitted from converter **560,** to scintillator element surface **600.** Converter **560** and scintillator element surface **600** (and grid **530** if used) may be electrically biased using an electrical biasing assembly **618** comprising a switchable high voltage power supply **620** coupled to a first voltage feedthrough **622** in electrical communication with scintillator element surface **600** so as to electrically bias scintillator element surface **600,** and a switchable high voltage bipolar power supply **630** coupled to a second and a third voltage feedthrough **632** and **634,** respectively, via a voltage divider **640.** Second voltage feedthrough **632** is in electrical communication with converter **560** so as to electrically bias it, and third voltage feedthrough **634** is in electrical communication with grid **530** so as to electrically bias grid **530.**

In accordance with an embodiment of the present invention, the conversion surface **564** may be shaped so as to minimize inhomogeneities in a detection efficiency of the charged particles **514** irrespective of their location along an interaction region **R** of the conversion surface **564.** The detection efficiency is defined as the conversion factor of a charged particle **514** impinging on conversion surface **564,** i.e. the number of electrons **590** emitted from conversion surface **564** per single impinging charged particle **514,** multiplied by the extraction efficiency of the emitted electrons **590,** i.e. the probability that an emitted electron **590** will impinge on the scintillator element surface **600.** It should be understood that the attraction force of the scintillator element surface **600** defined by the electrical field generated by the scintillator element surface **600** in the detection device may decrease as the detection distance, i.e. the distance of a location on the conversion surface **564** from the scintillator element surface **600,** increases. Thus, the extraction efficiency may decrease as the detection distance increases and in turn the detection efficiency may be inhomogenous along conversion surface **564.**

In order to compensate for the decreasing extraction efficiency, the conversion surface **564** is shaped so as to increase the conversion factor as the detection distance increases. Generally, the conversion factor may increase as a grazing angle of a particle **514** impinging on the conversion surface **564** decreases. Thus by forming the conversion surface **564** as a concave surface, wherein the grazing angle decreases as the detection distance increases, the conversion factor will increase as the detection distance increases and thus the detection efficiency inhomogeneity along the conversion surface **564** is minimized.

Turning to **Fig. 4****,** it is seen that due to the curvature of the conversion surface **564,** at a location **660** on conversion surface **564,** which is in relative proximity to the scintillator element surface **600,** the grazing angle **664** of a particle **666** impinging on conversion surface **564** is relatively large. Accordingly, at a location **670** on conversion surface **564,** which is in relative distance to the scintillator element surface **600,** the grazing angle **674** of a particle **676** impinging on conversion surface **564** is relatively small, thus the efficiency inhomogeneity along the conversion surface **564** is minimized. In a non-limiting example, upon impingement of potassium particles on a conversion surface formed of aluminum oxide, the conversion factor at a normal incidence angle is 5.27 and increases to 19.75 wherein the grazing angle is 10°.

It is appreciated that the curvature of the conversion surface **564** may be determined in accordance with the specific parameters, such as the detection distance, for example, of a given particle detection system. This can be achieved by simulating impingement of particles on a conversion surface within a given particle detection system so as to determine the optimal conversion surface curvature operative to provide a homogenous detection efficiency along the conversion surface.

It is further noted that the curvature of conversion surface **564** may be formed with a constant radius of curvature or, alternatively, with a variable radius of curvature.

As indicated above, grid **530** may be located at any suitable location inside or outside the housing **524,** and may not be used at all, in which case converter **560** is appropriately electrically biased to ensure that a charged particle **514** emitted from sample **510** will impinge upon conversion surface **564.**

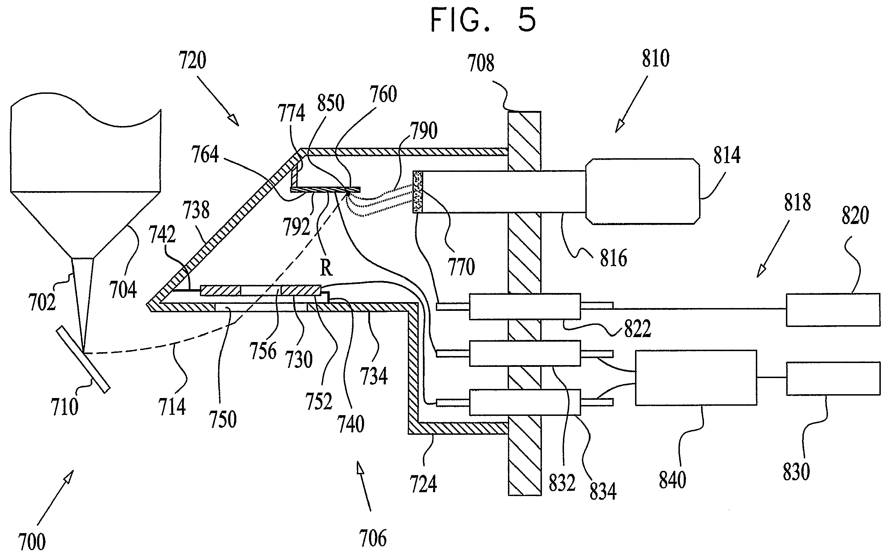

Reference is now made to **Fig. 5****,** which is a simplified sectional illustration of a particle detection system **700** constructed and operative in accordance with still another embodiment of the present invention. Particle detection system **700** comprises a particle beam **702** generated by a particle beam column **704,** which may comprise an FIB column, a dual beam column, an electron beam column, a helium beam column or any other suitable particle beam column. Column **704** is located within a detection system chamber **706** defined by chamber walls **708,** and operates to generate particle beam **702** to irradiate a sample **710** thus causing emission of a charged particle **714** (an electron, positive ion or a negative ion) from the sample **710.**

A detection device **720** comprises a housing **724** (formed of any suitable conductive material and is preferably set to an electrical potential of the detection system chamber **706**), a grid **730** (the provision of which is optional) mounted to housing walls **734** and **738** by respective mounting elements **740** and **742,** a converter **760** and an electron detector **810.** The charged particle **714** is directed to pass a housing aperture **750** defined within wall **734** towards grid **730** due to an appropriate electric field obtained by electrically biasing the grid **730** at a potential operative to attract the charged particle **714** thereto.

The charged particle **714** passes grid **730** to converter **760,** via a grid aperture **756,** preferably configured at a central location of planer surface **752** defined by grid **730.** Converter **760** may be formed with a conversion surface **764** defining a substantially planar continuous interaction region **R.** The planar conversion surface **764** is seen in **Fig. 5** to be generally perpendicular to a scintillator element surface **770** described in further detail hereinbelow. Converter **760** may be mounted to housing **724** by a mounting element **774** affixing conversion surface **764** to housing wall **738**.

Converter **760** is electrically biased at a potential operative to attract the charged particle **714** thereto such that the charged particle **714** impinges upon conversion surface **764** at its surface side **792,** and a plurality of electrons **790** are emitted from said surface side **792.** Thus, converter **760** operates as an ion-to-electron converter whereupon the charged particle **714** is a positive ion or a negative ion. Additionally, the same conversion surface operates as a particle **714** amplifier. For example, three electrons **790** may be emitted upon impingement of a single particle **714** on conversion surface **764**.

Electrons **790** impinge upon scintillator element surface **770** of electron detector **810**. The scintillator element surface **770** may be coupled to a light sensor, such as a photomultiplier tube **814** via a light guide **816** thereby yielding an electrical signal from electron detector **810**.

Converter **760** and scintillator element surface **770** (and grid **730** if used) are electrically biased so as to force a charged particle **714** emitted from sample **710** to pass to the interaction region **R** within the conversion surface of converter **760** and to attract resultant electrons **790** emitted from converter **760** to scintillator element surface **770.** Converter **760** and scintillator element surface **770** (and grid **730** if used) are appropriately electrically biased to create a desired electric field defining the trajectories of the emitted charged particle to interact with the converter. In the embodiment shown in **Fig. 5** an electrical biasing assembly **818** comprises a switchable high voltage power supply **820** coupled to a first voltage feedthrough **822** in electrical communication with scintillator element surface **770** so as to electrically bias scintillator element surface **770**, and a switchable high voltage bipolar power supply **830** coupled to a second and a third voltage feedthrough **832** and **834,** respectively, via a voltage divider **840**. Second voltage feedthrough **832** is in electrical communication with converter **760** so as to electrically bias converter **760** and third voltage feedthrough **834** is in electrical communication with grid **730** so as to electrically bias grid **730.**

The converter **760** (and grid **730**) may be positioned relative to sample **710** and may be electrically biased to ensure that a charged particle 714 emitted from sample **710** will be attracted to the interaction region **R** of converter **760.** Additionally, the converter **760** (and grid **730**) may be positioned relative to sample **710** and may be electrically biased to ensure that a charged particle **714** interacts with the conversion surface **764** at a location wherein an attraction force generated by scintillator element surface **770** is greatest so as to ensure that a resultant electron emitted from converter **760** is attracted to scintillator element surface **770.** This location **850** is proximal to the scintillator element surface **770.**

It will be appreciated by persons skilled in the art that the present invention is not limited by what has been particularly shown and described herein above.

The invention is limited only by the scope of the appended claims.

## Claims

1. A charged particle detector device (12, 120) for detecting a charged particle emitted from a sample (16, 110), the detector device comprising:
a converter (26,160) defining a conversion surface (40,164) with a continuous region (R) of interaction of incident charged particles of different types (14,114) comprising positive and negative ions and electrons, said conversion surface being adapted for emitting electrons (27,194) in response to interaction with the charged particles of different types;
an electron detector (28, 210) for receiving electrons from the converter and generating output data indicative thereof, and
an electric field generator (38) configured and operable to create an electric field defining trajectories for charged particles of different types (14,114) emitted from the sample (16, 110) as a result of the sample interaction with a particle beam (20,102), the emitted charged particles of different types being one of the following: electrons, positive ions and negative ions,
said converter (26,160) having a conversion surface (40,164) comprising the continuous interaction region (R) oriented so as to intersect the trajectories of the charged particles of different types propagating from the sample, said conversion surface operative to emit electrons (27,194) in response to the surface interaction with the charged particles of different types,
**characterized in that**
the electric field created within the detection device defines an operational mode of the device to selectively allow detection of electrons, positive ions and negative ions.

2. A device according to claim 1, wherein said conversion surface (40,164) is curved or planar.

3. A device according to claim 1, wherein the converter (26,160) has a cross section of a right triangle geometry with a hypotenuse comprising said conversion surface (40,164) with the continuous interaction region (R).

4. A device according to any one of claims 1-3, comprising a grid-like electrode (32, 130) accommodated upstream of the converter (26,160) for directing the charged particles (14,114) towards said interaction region (R).

5. A device according to any one of claims 1-4, wherein said electron detector (28, 210) comprises a scintillator element surface (44, 200).

6. A device according any one of claims 1-5, wherein the conversion surface (40,164) has a non-planar shape selected to minimize detection efficiency inhomogeneity within said device (12, 120).

7. A charged particle detection system (10, 100) comprising:
a particle beam column (18, 104) for generating a particle beam (20,102) for exciting the sample (16, 110) to thereby cause emission of charged particles of different types (14,114) therefrom, the emitted charged particles comprising at least one positive ion, negative ion and electron; and
a charged particle detection device (12, 120) according to any one of one of claims 1-6.

8. A system according to claim 7 and claim 4,
wherein the grid-like electrode (32, 130) is provided to direct the charged particles (14,114) emitted from the sample (16, 110) to said region (R) of interaction.

9. A system according to claim 7 or 8, wherein the particle beam column (18, 104) comprises a focused ion beam (FIB) column, a dual beam column, an electron beam column or a helium beam column.

10. A method for use in detecting charged particles of different types (14,114) emitted from a sample (16, 110), the method comprising:
creating an electric field in a path of charged particles of different types emitted from the sample so as to direct the charged particles of different types along a trajectory towards a charged particle converter (26,160), said charged particles of different types being one of the following: a positive ion, a negative ion and an electron;
providing a continuous interaction region (R) of the converter oriented to intersect trajectories of the charged particles of different types propagating towards the converter, said interaction region being responsive to the charged particle incidence thereon to emit electrons (27,194); and
detecting the emitted electrons and generating output data indicative thereof,
**characterized in that**
the electric field created within the detection device defines an operational mode of the device to selectively allow detection of electrons, positive ions and negative ions.

## Patentansprüche

1. Detektorvorrichtung für geladene Teilchen (12, 120) zum Detektieren eines von einer Probe (16, 110) emittierten geladenen Teilchens, wobei die Detektorvorrichtung umfasst:
einen Konverter (26, 160) welcher eine Konversionsoberfläche (40, 164) definiert mit einer kontinuierlichen Wechselwirkungsregion (R) für einfallende geladene Teilchen unterschiedlichen Typs (14, 114), umfassend positive und negative Ionen und
Elektronen, wobei die Konversionsoberfläche dazu geeignet ist, in Reaktion auf die Wechselwirkung mit den geladenen Teilchen unterschiedlichen Typs Elektronen (27, 194) zu emittieren;
einen Elektronendetektor (28, 210) zum Empfangen von Elektronen von dem Konverter und zum Erzeugen von auf diese hinweisenden Ausgabedaten; und
einen elektrischen Feldgenerator (38), der zum Erzeugen eines elektrischen Feldes eingerichtet und betriebsbereit ist, das Trajektorien für geladenen Teilchen unterschiedlichen Typs (14, 114) definiert, die als Resultat der Wechselwirkung der Probe mit einem Teilchenstrahl (20, 102) von der Probe emittiert sind, wobei die emittierten geladenen Teilchen unterschiedlichen Typs eines der folgenden sind: Elektronen, positive Ionen und negative Ionen,
wobei der Konverter (26, 160), der eine Konversionsoberfläche (40, 164) hat, welche die kontinuierliche Wechselwirkungsregion (R) aufweist, die ausgerichtet ist, um die Trajektorien der geladenen Teilchen unterschiedlichen Typs zu schneiden, die sich von der Probe fortbewegen, wobei die Konversionsoberfläche dazu geeignet ist, in Reaktion auf die Wechselwirkung mit den geladenen Teilchen unterschiedlichen Typs Elektronen (27, 194) zu emittieren;
**dadurch gekennzeichnet, dass**
das in der Detektionsvorrichtung erzeugte elektrische Feld eine Betriebsart der Vorrichtung definiert, um selektiv die Detektion von Elektronen, positiven Ionen, und negativen Ionen zu ermöglichen.

2. Vorrichtung nach Anspruch 1, wobei Konversionsoberfläche (40, 164) gekrümmt oder eben ist.

3. Vorrichtung nach Anspruch 1, wobei der Konverter (26, 160) einen Querschnitt mit der Geometrie eines rechtwinkligen Dreiecks aufweist, mit einer Hypotenuse, weiche die Konversionsoberfläche(40, 164) mit der kontinuierlichen Wechselwirkungsregion (R)aufweist.

4. Vorrichtung nach einem der Ansprüche 1 bis 3, umfassend: eine gitterartige Elektrode (32, 130) die vor dem Konverter (26, 160) platziert ist, um die geladenen Teilchen (14, 114) in Richtung der Wechselwirkungsregion (R) zu lenken.

5. Vorrichtung nach einem der Ansprüche 1 bis 4, wobei der Elektronendetektor (28, 210) eine Szintillatorelementoberfläche (44, 200) aufweist.

6. Vorrichtung nach einem der Ansprüche 1 bis 5, wobei die Konversionsoberfläche (40, 164) eine nicht-ebene Form hat, die gewählt ist um eine Inhomogenität in der Detektionseffizienz innerhalb der Vorrichtung (12, 120) zu minimieren.

7. System (10, 100) zum Detektieren geladener Teilchen, umfassend:
eine Teilchenstrahlsäule (18, 104) zum Erzeugen eines Teilchenstrahls (20, 102) zum Anregen der Probe (16, 110) um dadurch die Emission geladener Teilchen unterschiedlichen Typs (14, 114) von der Probe zu verursachen, wobei die geladenen Teilchen zumindest eines von Elektronen, positive Ionen und negative Ionen umfassen; und
eine Detektorvorrichtung für geladene Teilchen (12, 120) nach einem der Ansprüche 1 bis 6.

8. System nach Anspruch 7 und 4, wobei die gitterartige Elektrode (32, 130) bereitgestellt ist, um die geladenen Teilchen (14, 114), welche von der Probe emittiert sind, in Richtung der Wechselwirkungsregion (R) zu lenken.

9. System nach Anspruch 7 oder 8, wobei die Teilchenstrahlsäule (18, 104) eine fokussierte Ionenstrahlsäule, eine Dualstrahlsäule, eine Elektronenstrahlsäule oder eine Heliumstrahlsäule umfasst.

10. Verfahren zum Verwenden beim Detektieren geladener Teilchen unterschiedlichen Typs (14, 114), die von einer Probe (16, 116) emittiert wurden, wobei das Verfahren umfasst:
Erzeugen eines elektrischen Feldes in einem Pfad geladener Teilchen unterschiedlichen Typs, die von der Probe emittiert sind, um die geladenen Teilchen unterschiedlichen Typs entlang einer Trajektorie in Richtung eines Konverters (26, 160) für geladene Teilchen zu lenken, wobei die geladenen Teilchen unterschiedlichen Typs eines der folgenden sind: ein positives Ion, ein negatives Ion oder ein Elektron;
Bereitstellen einer kontinuierlichen Wechselwirkungsregion (R) des Konverters, die ausgerichtet ist, um die Trajektorien der geladenen Teilchen unterschiedlichen Typs zu schneiden, die sich zu dem Konverter bewegen, wobei die Wechselwirkungsregion (R) reagierend auf den Einfall geladener Teilchen ist um Elektronen (27, 194) zu emittieren; und
Detektieren der Elektronen und Erzeugen von auf diese hinweisenden Ausgabedaten,
**dadurch gekennzeichnet, dass**
das in der Detektionsvorrichtung erzeugte elektrische Feld eine Betriebsart der Vorrichtung definiert um selektiv die Detektion von Elektronen, positiven Ionen und negativen Ionen zu ermöglichen.

## Revendications

1. Dispositif détecteur de particule chargée (12, 120) pour détecter une particule chargée émise à partir d'un échantillon (16, 110), le dispositif détecteur comprenant :
un convertisseur (26, 160) définissant une surface de conversion (40, 164) avec une région continue (R) d'interaction de particules chargées incidentes de types différents (14, 114) comprenant des ions positifs et négatifs et des électrons, ladite surface de conversion étant conçue pour émettre des électrons (27, 194) en réponse à une interaction avec les particules chargées de types différents ;
un détecteur d'électrons (28, 210) pour recevoir des électrons du convertisseur et produire des données de sortie indicatives de ceux-ci et
un producteur de champ électrique (38) conçu et exploitable pour créer un champ électrique définissant des trajectoires pour des particules chargées de types différents (14, 114) émises à partir de l'échantillon (16, 110) en conséquence de l'interaction de l'échantillon avec un faisceau de particules (20, 102), les particules chargées émises de types différents étant un des éléments suivants : électrons, ions positifs et ions négatifs,
ledit convertisseur (26, 160) possédant une surface de conversion (40, 164) comprenant la région d'interaction continue (R) orientée de façon à couper les trajectoires des particules chargées de types différents se propageant à partir de l'échantillon, ladite surface de conversion étant opérationnelle pour émettre des électrons (27, 194) en réponse à l'interaction de surface avec les particules chargées de types différents,
**caractérisé en ce que**
le champ électrique créé au sein du dispositif de détection définit un mode opérationnel du dispositif pour permettre de façon sélective la détection d'électrons, d'ions positifs et d'ions négatifs.

2. Dispositif selon la revendication 1, dans lequel ladite surface de conversion (40, 164) est courbée ou plane.

3. Dispositif selon la revendication 1, dans lequel le convertisseur (26, 60) possède une coupe transversale d'une géométrie de triangle rectangle avec une hypoténuse comprenant ladite surface de conversion (40, 164) avec la région d'interaction continue (R).

4. Dispositif selon l'une quelconque des revendications 1 à 3, comprenant une électrode de type grille (32, 130) logée en amont du convertisseur (26, 160) pour diriger les particules chargées (14, 114) en direction de ladite région d'interaction (R).

5. Dispositif selon l'une quelconque des revendications 1 à 4, dans lequel ledit détecteur d'électrons (28, 210) comprend une surface d'éléments scintillateurs (44, 200).

6. Dispositif selon l'une quelconque des revendications 1 à 5, dans lequel la surface de conversion (40, 164) possède une forme non plane sélectionnée de façon à réduire au minimum l'inhomogénéité d'efficacité de détection au sein dudit dispositif (12, 120).

7. Système de détection de particule chargée (10, 100) comprenant :
une colonne de faisceau de particules (18, 104) pour produire un faisceau de particules (20, 102) pour exciter l'échantillon (16, 110) de façon à provoquer ainsi l'émission de particules chargées de types différents (14, 114) à partir de celui-ci, les particules chargées émises comprenant au moins un ion positif, un ion négatif et un électron ; et
un dispositif de détection de particule chargée (12, 120) selon l'une quelconque des revendications 1 à 6.

8. Système selon la revendication 7 et la revendication 4,
dans lequel l'électrode de type grille (32, 130) est fournie pour diriger les particules chargées (14, 114) émises à partir de l'échantillon (16, 110) vers ladite région (R) d'interaction.

9. Système selon la revendication 7 ou 8, dans lequel la colonne de faisceau de particules (18, 104) comprend une colonne de faisceau ionique focalisé (FIB), une colonne de faisceau double, une colonne de faisceau d'électrons ou une colonne de faisceau d'hélium.

10. Procédé destiné à être utilisé dans la détection de particules chargées de types différents (14, 114) émises à partir d'un échantillon (16, 110), le procédé comprenant :
la création d'un champ électrique dans une voie de particules chargées de types différents émises à partir de l'échantillon de façon à diriger les particules chargées de types différents le long d'une trajectoire en direction d'un convertisseur de particules chargées (26, 60), lesdites particules chargées de types différents étant l'un des éléments suivants : un ion positif, un ion négatif et un électron ;
la fourniture d'une région d'interaction continue (R) du convertisseur orientée pour couper les trajectoires des particules chargées de types différents se propageant en direction du convertisseur, ladite région d'interaction étant réactive à l'incidence de particules chargées sur celle-ci pour émettre des électrons (27,194) ; et
la détection des électrons émis et la production de données de sortie indicatives de ceux-ci,
**caractérisé en ce que**
le champ électrique créé au sein du dispositif de détection définit un mode opérationnel du dispositif pour permettre de façon sélective la détection d'électrons, d'ions positifs et d'ions négatifs.
